# EUROPEAN PATENT SPECIFICATION

(11) **EP 4 078 815 B1**
(45) Date of publication and mention of the grant of the patent: **28.01.2026**
(21) Application number: 20700090.2
(22) Date of filing: 02.01.2020
(51) Int. Cl.: H03M 1/56

(54) **ANALOG-TO-DIGITAL CONVERTER WITH SINGLE COUNTER CIRCUIT**
ANALOG-DIGITAL-WANDLER MIT EINER EINZIGEN ZÄHLERSCHALTUNG
CONVERTISSEUR ANALOGIQUE-NUMÉRIQUE À CIRCUIT COMPTEUR UNIQUE

(43) Date of publication of application: 26.10.2022
(73) Proprietor: Huawei Technologies Co., Ltd., Shenzhen, Guangdong 518129, (CN)
(72) Inventor: HELSEN, Mathias, 80992 Munich (DE); BORREMANS, Marc, 80992 Munich (DE); WOLFS, Bram, 80992 Munich (DE)
(74) Representative: Gill Jennings & Every LLP
(86) International application number: PCT/EP2020/050012
(87) International publication number: WO 2021/136591

(56) References cited:
- WO-A1-2017/076748
- US-A1- 2014 203 956
- US-B2- 8 576 979
- US-B2- 8 618 974

## Description

### TECHNICAL FIELD

The present disclosure relates to an analog-to-digital converter (ADC) with single counter circuit, in particular an ADC with a ramp ADC dual clock edge counter using single counter circuit with signal independent power consumption. The disclosure particularly relates to column parallel ADCs which may be used in CMOS image sensors.

### BACKGROUND

Image sensors typically contain a large amount of ADCs, one per column of a pixel array, and need to fit a very small pitch which is equal to the pixel pitch. For such image sensor ADCs the following constraints are to be met: the power supply must be well controlled to avoid influencing of one ADC by one or multiple of the other parallel operating ADC's. Possible crosstalk between two ADCs would be very visible in the image and would disturb the picture quality. Generally, the A/D converters are the main contributors in image sensors. Specifically, with ramp type ADC's, the counting clock signal runs at high frequency and is distributed over the entire width of the pixel array. To limit power consumption it is beneficial to count on both edges of the counting clock signal. This halves the clock frequency needed to operate the counter compared to single edge counting, while maintaining the same counter resolution per given conversion time. The circuit needs to be as compact as possible.

The simplest solution is the use of a single counter. This limits area but does not address the reduced clock frequency and constant power consumption. This solution potentially suffers from crosstalk in between ADC's due to a shared and poorly controlled power supply.

An existing solution which addresses both the lowered clock frequency and constant power consumption is described in US patent application publication US 2014/0203956 A1, where examples are shown in Figures 1 and 2. A detailed explanation of the functioning of said existing solution is provided in US 2014/0203956 A1, of which the skilled person is familiar.

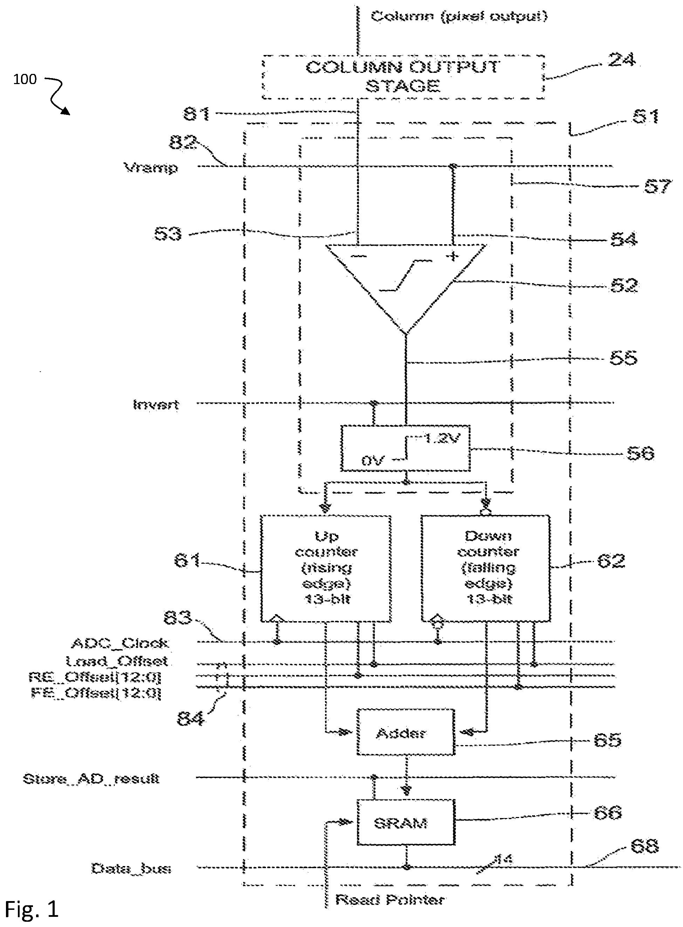

Fig. 1 shows the architecture of one of the column analog-to-digital converters introduced in the above-referenced application. The single column ADC 100 contains two counters: one up-counter 61 (rising edge) and one down counter 62 (falling edge).

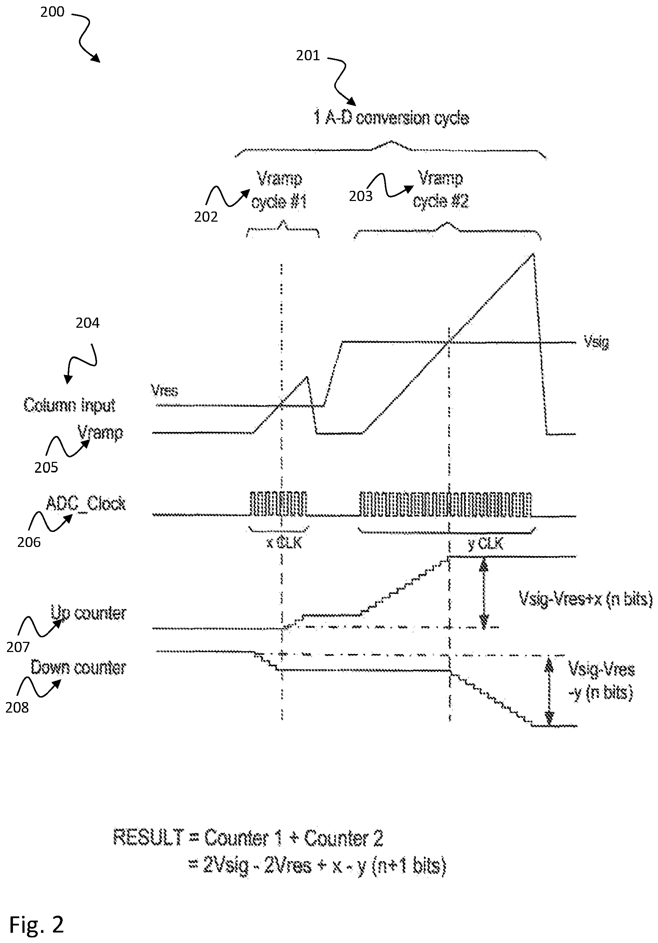

The timing diagram in Figure 2 shows the typical operation of such ramp ADC 100 in an image sensor. The purpose of the ADC 100 is to directly convert the difference between the reset signal level (Vᵣₑₛ) and the integrated pixel signal level (V_{sig}). To do this, the rising edge up-counter 61 is active when the ramp signal (Vᵣₐₘₚ) 205 crossed the reset signal Vᵣₑₛ and before the ramp signal 205 crossed the integrated pixel signal 204. The down counter 62 activity is complementary to the up-counter 61. The total number of ADC clock cycles is pre-determined: 'x' clock cycles for reset conversion, 'y' clock cycles for signal conversion. When both counter values are summed (by the adder 65), the resulting ADC value returns a linear measure, as shown in the equation of Figure 2, for the difference between V_{sig} and Vᵣₑₛ plus a fixed offset, which can be adjusted in data post-processing.

The disadvantage of such existing solution is that two counters per pixel column are required, and hence a large area per ADC is required.

WO 2017/076748 A1 also describes an analog-to-digital converter for an imaging device.

### SUMMARY

The disclosure provides techniques for solving the above described problems. In particular, the disclosure provides an ADC for use in image sensors with limited power consumption and improved cross-talk characteristics that allows smaller circuit layout and smaller pixel pitch than existing solutions.

The features of the independent claims provide a solution realising such techniques. Further implementation forms are provided by the dependent claims, the description and the figures.

A solution according to the disclosure as described hereinafter introduces a novel ADC architecture that is based on a single counter circuit. Power consumption of the ADC is independent of the converted signal because the counter is always active. This can assure a signal independent supply and ground for each individual ADC of an ADC sensor array. As such cross talk through supply and ground nets between parallel ADC's can be avoided.

One basic concept of the disclosure can be summarized as replacing a circuit containing up-counter, down-counter and adder per column ADC by a single counter per column ADC, which allows both up-and down counting and is able to toggle in a dynamic manner, i.e., without stopping the input clock signal, during the ongoing AD conversion. Thus, one of the two counters, as well as the adder circuit, of the solution in US 2014/0203956 A1 can be eliminated.

According to a first aspect, the disclosure relates to an analog-to-digital converter (ADC) for enabling a calculation of a difference between a first analog signal level (Vsig) and a second analog signal level (Vres), the ADC comprising: at least one input for receiving an input signal, comprising one of the first analog signal level (Vsig) and the second analog signal level (Vres); an input for receiving a ramp signal (Vramp); an input for receiving an input clock (CLK); a counter, configurable to count in a counting direction being either of a first counting direction and a second counting direction; a comparator, configured to generate a comparator output signal based on a comparison of the ramp signal (Vramp) with the input signal; and a control stage, configured to enable the counter to count in the first counting direction based on the comparator output signal, and to enable the counter to count in the second counting direction based on an inversion of the comparator output signal.

With such ADC, the power consumption is independent of the converted signal because the counter is always active. This assures a signal independent supply and ground for each individual ADC used in an ADC array, e.g. an ADC array of an image sensor. As such cross talk through supply and ground nets between parallel ADCs can be avoided. When illuminating an image sensor using an array of such ADCs, the consumption of the image sensor does not depend on the illumination level.

The first counting direction can be count up, and the second counting direction can be count down, or vice versa.

There may be a correspondence between an initial counting direction of the counter and the particular input signal or conversion. The correspondence may be that the initial counting direction when the first analog signal level is initially input is in the first counting direction, and the initial counting direction when the second analog signal level is initially input is in the second counting direction. In other words, for each input signal, the initial counting directions are opposite to each other during a first time part of each input signal.

The input signals may be input sequentially, e.g. first analog signal level (Vsig) is input and that is followed by the second analog signal level (Vres).

The control stage is configured to invert the counting direction of the counter during a conversion of one of the input signals without stopping the input clock (CLK).

This provides the technical advantage that inverting the counting direction of the counter has no influence on the clocking of the ADC.

Inverting the counting direction without stopping the input clock enables toggling in a dynamic manner during a conversion. This enables the counter to be (on average) continuously active during a conversion, which assures a signal independent supply and ground for each individual ADC. As such cross talk through supply and ground nets between parallel ADC's is avoided.

In an exemplary implementation form of the ADC, the counter comprises a plurality of flip-flops connected in series, in particular JK flip-flops or T flip-flops.

This provides the technical advantage that the counter can be easily implemented by using standard hardware circuits.

The counter may implement as an asynchronous binary ripple counter.

A number of flip-flops of the counter may be in correspondence to a predefined resolution of the ADC. This provides the technical advantage that a resolution (and complexity) of the ADC is scalable depending on the design of the counter.

In an exemplary implementation form of the ADC, the counter comprises a plurality of multiplexer cells, each multiplexer cell connected between an output and an input of two consecutive flip-flops of the counter, wherein the control stage is configured to invert the counting direction of the counter by toggling the multiplexer cells in between the flip-flops.

This provides the technical advantage that using such kind of multiplexing allows to design counting direction inversion in an efficient way.

In an exemplary implementation form of the ADC, the control stage is configured to let a last clock cycle of the input clock (CLK) completely pass through the counter before toggling the multiplexer cells. In an exemplary implementation form of the ADC, a number of flip-flops of the state machine circuitry is predetermined according to a delay for a settled counter state preceding the inversion of the counting direction.

This provides the technical advantage that the counter is in a predefined state before each inversion of the counting direction.

In an exemplary implementation form, the ADC comprises a state machine circuitry composed of a plurality of flip-flops connected in series.

This provides the technical advantage that such state machine circuitry can be efficiently used to control the counter states.

In an exemplary implementation form of the ADC, the control stage is configured to trigger the state machine circuitry based on the inversion of the comparator output signal.

This provides the technical advantage that the state machine can be synchronized with the comparator output signal, i.e. the difference between the ramp signal and the input signal.

Inversion of the comparator output signal is from the result of the comparison of the input signal with the Vramp during a conversion.

The control stage may also be configured to trigger the counter to enter a frozen state. This may happen at the same time as triggering the state machine circuitry, also based on the inversion of the comparator output signal.

The delay is predetermined and may be measured in a predetermined number of clock pulses. This allows an error-free counting direction change.

In an exemplary implementation form of the ADC, the counter comprises a clock control circuitry configured to enable a clocking of the counter based on the inversion of the comparator output signal and an output signal of the state machine circuitry signaling a settled counter state.

This provides the technical advantage that the counter can be synchronized with the clock signals and the comparator output signal, i.e., the difference between the ramp signal and the input signal.

Counter state being settled or not is not determined by the circuitry disclosed herein. Merely a time is allowed for a settled state to occur.

In an exemplary implementation form, the ADC comprises an input for receiving an inverted input clock (CLK_B) corresponding to the input clock (CLK) inverted by an inverter.

This provides the technical advantage that the counter can count two ADC counts per clock cycle.

In an exemplary implementation form of the ADC, the state machine circuitry comprises a clock control circuitry configured to enable a clocking of the state machine circuitry based on the inverted input clock (CLK_B) or based on the input clock (CLK).

This provides the technical advantage that the state machine circuitry can be clocked on rising as well as on falling edges of the clock signal, thereby implementing two ADC counts per clock cycle.

In an exemplary implementation form of the ADC, the control stage is configured to: de-activate a clocking of the counter by the input clock (CLK) based on the inversion of the comparator output signal; and activate a clocking of the state machine circuitry by the inverted input clock (CLK_B) upon a de-activation of the clocking of the counter by the input clock (CLK).

This provides the technical advantage that a conversion between up-counting and down-counting can be efficiently implemented.

In an exemplary implementation form of the ADC, the counter is configured to perform two counts per clock cycle of the input clock (CLK).

This provides the technical advantage that both up-counting and down-counting can be implemented within a single clock cycle of the input clock of the ADC.

In an exemplary implementation form of the ADC, the ADC is configured to clock the counter on one edge of the input clock (CLK) and to clock the state machine circuitry on the other edge of the input clock (CLK).

This provides the technical advantage that a flexible clocking can be implemented.

The ADC uses only a single counter to count in either of the first counting direction and the second counting direction.

This provides the technical advantage that by using a single counter, hardware resource can be saved and the design of the ADC is easy to implement.

In an exemplary implementation form of the ADC, the counter is up/down reversible in response to a direction control signal from the state machine circuitry based on the comparator output signal.

This provides the technical advantage that a flexible up/down counting can be implemented.

In an exemplary implementation form of the ADC, the ADC is configured to enable the calculation of the difference between the first analog signal level (Vsig) and the second analog signal level (Vres) without using an adder.

This provides the technical advantage that by using no adder, hardware resources can be saved and the design of the ADC is easy to implement.

The ADC provides an output code that is based on the outputs (Q outputs) of the counter (JK or T) flip-flops (B0, B1, B2, B3). No adder is required to provide an output value.

In an exemplary implementation form of the ADC, the control stage is configured, for conversion of one of the input signals only, to invert the comparator output signal in response to an inversion control signal and provide the thereby inverted comparator output signal to the counter.

This provides the technical advantage that this is the way the subtraction of the input signals from each other is obtained. Without this controlled inversion, only addition is possible.

In an exemplary implementation form of the ADC, the counting direction is changed during a first conversion of one of the input signals and then kept for a second conversion of the one of the input signals.

This provides the same technical advantage as above, i.e., that this is the way the subtraction of the input signals is obtained. Without this controlled inversion, only addition is possible.

According to a second aspect, the disclosure relates to a method for enabling a calculation of a difference between a first analog signal level (Vsig) and a second analog signal level (Vres), the method comprising: receiving an input signal, comprising one of the first analog signal level (Vsig) and the second analog signal level (Vres); receiving a ramp signal (Vramp); receiving an input clock (CLK); counting, by a counter, in a counting direction being either of a first counting direction and a second counting direction; generating a comparator output signal based on a comparison of the ramp signal (Vramp) with the input signal; and enabling the counter to count in the first counting direction based on the comparator output signal, and enabling the counter to count in the second counting direction based on an inversion of the comparator output signal.

By using such a method, power consumption is independent of the converted signal because the counter is always active. This assures a signal independent supply and ground for each individual conversion. An ADC array, e.g. in a sensor array, using such method will have superior cross talk characteristics, since cross talk through supply and ground nets between parallel ADCs can be avoided. When illuminating an image sensor comprising an ADC array which is based on such a method, the consumption of the image sensor is independent of the illumination level.

The entities described in this disclosure may include processors or processing circuits to process the respective functionalities. A processor as described in this disclosure may comprise hardware and/or software. The hardware may comprise digital circuitry, or both analog and digital circuitry. Digital circuitry may comprise components such as application-specific integrated circuits (ASICs), field-programmable arrays (FPGAs), digital signal processors (DSPs), or general-purpose processors. In one embodiment, the processor comprises one or more processor cores and a non-transitory memory connected to the one or more processor cores. The non-transitory memory may carry executable program code which, when executed by the one or more processor cores, causes the apparatus to perform the operations or methods described herein.

### BRIEF DESCRIPTION OF THE DRAWINGS

Further embodiments of the invention will be described with respect to the following figures, in which:
Fig. 1 shows a block diagram illustrating an existing solution for a column ADC 100 in an image sensor with two counters (up- and down-) and one adder;
Fig. 2 shows a timing diagram 200 of the column ADC 100 shown in Fig. 1;
Fig. 3 shows a block diagram of an ADC 300 with a single (up/down) counter according to the disclosure;
Fig. 4 shows an exemplary timing diagram 400 of the ADC 300 shown in Fig. 3;
Fig. 5 shows a block diagram of an exemplary counter circuitry 500 according to the disclosure for use in the ADC 300 shown in Fig. 3;
Fig. 6a shows an exemplary timing diagram 601 illustrating the 2-counts-per-clock-cycle operation of the ADC 300 shown in Fig. 3, where the comparator toggles after 2.5 clock cycles;
Fig. 6b shows an exemplary timing diagram 602 illustrating the 2-counts-per-clock-cycle operation of the ADC 300 shown in Fig. 3, where the comparator toggles after 3.0 clock cycles; and
Fig. 6c shows an exemplary timing diagram 603 illustrating the 2-counts-per-clock-cycle operation of the ADC 300 shown in Fig. 3, where the comparator toggles after 3.5 clock cycles.

### DETAILED DESCRIPTION OF EMBODIMENTS

In the following detailed description, reference is made to the accompanying drawings, which form a part thereof, and in which is shown by way of illustration specific aspects in which the disclosure may be practiced. It is understood that other aspects may be utilized and structural or logical changes may be made without departing from the scope of the present disclosure. The following detailed description, therefore, is not to be taken in a limiting sense, and the scope of the present disclosure is defined by the appended claims.

It is understood that comments made in connection with a described method may also hold true for a corresponding device or system configured to perform the method and vice versa. For example, if a specific method step is described, a corresponding device may include a unit to perform the described method step, even if such unit is not explicitly described or illustrated in the figures. Further, it is understood that the features of the various exemplary aspects described herein may be combined with each other, unless specifically noted otherwise.

The described devices may include integrated circuits and/or passive circuit elements and may be manufactured according to various technologies. For example, the circuits may be designed as logic integrated circuits, analog integrated circuits, mixed signal integrated circuits, optical circuits, memory circuits and/or integrated passives.

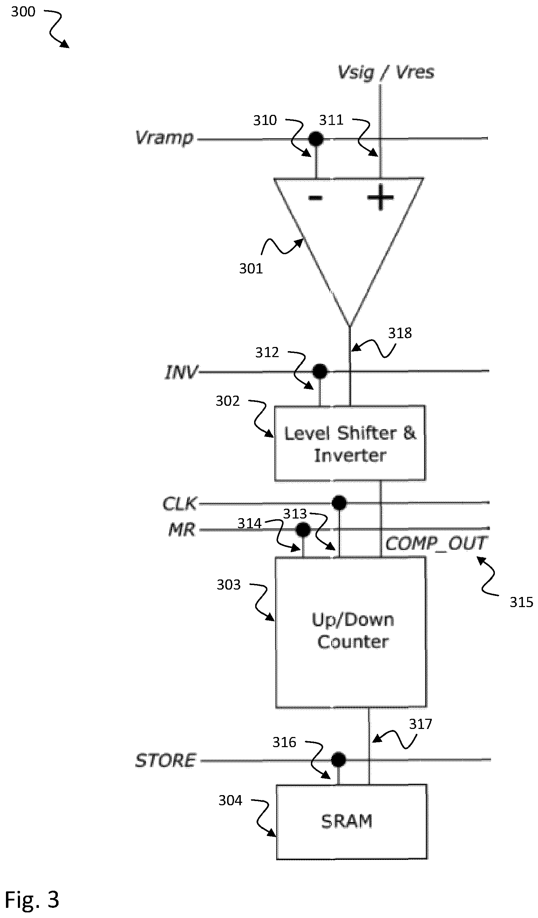

Fig. 3 shows a block diagram of an ADC 300 with a single (up/down) counter according to the disclosure.

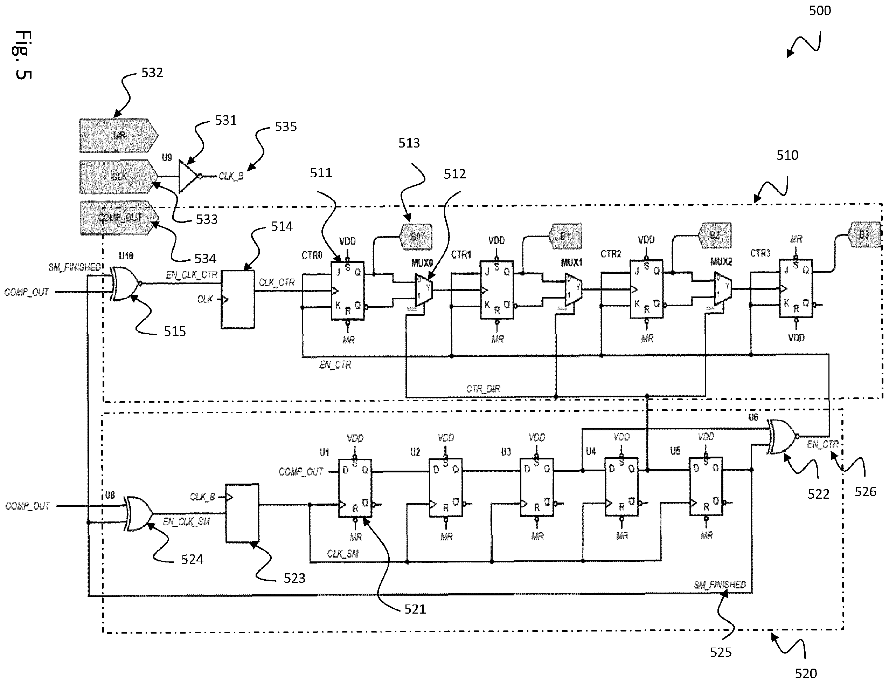

The ADC 300 includes a comparator 301, a level shifter and inverter 302, an up/down counter 303 and a memory, e.g. SRAM 304. The comparator 301 receives a ramp signal Vᵣₐₘₚ at a first input 310, e.g. negative input (-), and a reset signal Vᵣₑₛ / integrated pixel signal V_{sig} at a second input 311, e.g. positive input (+). The comparator 301 provides a comparator output signal, COMP_OUT, based on a comparison of the ramp signal Vᵣₐₘₚ and the reset signal Vᵣₑₛ / integrated pixel signal V_{sig} at its output 318 which is connected to a first input of the level shifter and inverter 302. At a second input 312 of the level shifter and inverter 302 an inversion signal (INV) is received. Depending on the state of the inversion signal (INV), the level shifter and inverter 302 provides the comparator output signal COMP_OUT or the inverted comparator output signal at its output that is connected to a first input 315 of the counter 303. The Up/Down counter 303 provides a counting result at its output 317 depending on the comparator output signal COMP_OUT, a clock signal CLK at a second input of the counter 303 and an MR signal at a third input 314 of the counter 303 according to a counter logic. An example of such a counter logic is shown in Figure 5 described below. The output 317 of the counter 303 is connected to a first input of the SRAM 304. The counting result can be stored in the SRAM 304 depending on a STORE signal provided at another input 316 of the SRAM 304.

The analog-to-digital converter 300 can be used for enabling a calculation of a difference between a first analog signal level Vsig and a second analog signal level Vres. The ADC 300 comprises: at least one input 311 for receiving an input signal, comprising one of the first analog signal level Vsig and the second analog signal level Vres; an input 310 for receiving a ramp signal Vramp; an input 313 for receiving an input clock CLK; a counter 303, configurable to count in a counting direction being either of a first counting direction and a second counting direction; a comparator 301, configured to generate a comparator output signal based on a comparison of the ramp signal Vramp with the input signal; and a control stage (not shown in Fig. 3), configured to enable the counter 303 to count in the first counting direction based on the comparator output signal, and to enable the counter 303 to count in the second counting direction based on an inversion of the comparator output signal.

The control stage may invert the counting direction of the counter 303 during a conversion of one of the input signals without stopping the input clock CLK. The counter 303 may be implemented according to the description of the counter 510 with respect to Fig. 5. The counter 303 may comprise a plurality of flip-flops 511 connected in series, e.g. as described below with respect to Fig. 5. These flip-flops may be realized as JK flip-flops or T flip-flops. A number of flip-flops 511 of the counter 303, 510 can be in correspondence to a predefined resolution of the ADC 300. I.e. for a high resolution ADC a higher number of flip-flops is required than for a low resolution ADC.

The counter 303 may comprise a plurality of multiplexer cells (MUX0, MUX1 etc) 512, each multiplexer cell 512 being connected between an output and an input of two consecutive flip-flops 511 of the counter 303, 510, e.g. as shown in Fig. 5. The control stage may be configured to invert the counting direction of the counter 303, 510 by toggling the multiplexer cells 512 in between the flip-flops 511.

In an exemplary implementation, the control stage may be configured to let a last clock cycle of the input clock CLK completely pass through the counter 303, 510 before toggling the multiplexer cells 512.

In an exemplary implementation, the ADC 300 comprises a state machine circuitry 520 composed of a plurality of flip-flops 521 connected in series, e.g. as described below with respect to Fig. 5. The control stage may be configured to trigger the state machine circuitry 520 based on the inversion of the comparator output signal COMP_OUT.

A number of flip-flops 521 of the state machine circuitry 520 may be predetermined according to a delay for a settled counter state preceding the inversion of the counting direction.

In an exemplary implementation, the counter 303, 510 comprises a clock control circuitry 514 configured to enable a clocking of the counter 303, 510 based on the inversion of the comparator output signal COMP_OUT and an output signal 526 of the state machine circuitry 520 signaling a settled counter state, e.g. as described below with respect to Fig. 5.

In an exemplary implementation, the ADC 300 may comprise an input 535 for receiving an inverted input clock CLK_B corresponding to the input clock CLK inverted by an inverter 531, e.g. as shown in Fig. 5. The state machine circuitry 520 may comprises a clock control circuitry 523 configured to enable a clocking of the state machine circuitry 520 based on the inverted input clock CLK_B or based on the input clock CLK, e.g. as shown in Fig. 5.

The control stage may be configured to de-activate a clocking of the counter 303, 510 by the input clock CLK based on the inversion of the comparator output signal; and activate a clocking of the state machine circuitry 520 by the inverted input clock CLK_B upon a de-activation of the clocking of the counter 303, 510 by the input clock CLK.

The counter 303, 510 may perform two counts per clock cycle of the input clock CLK.

The ADC 300 may be configured to clock the counter 303 on one edge of the input clock CLK and to clock the state machine circuitry 520 (shown in Fig. 5) on the other edge of the input clock CLK.

The ADC 300 uses only a single counter to count in either of the first counting direction and the second counting direction.

The counter 303 may be up/down reversible in response to a direction control signal from the state machine circuitry 520 (shown in Fig. 5) based on the comparator output signal.

The ADC 300 may be configured to enable the calculation of the difference between the first analog signal level Vsig and the second analog signal level Vres without using an adder.

The control stage may be configured, for conversion of one of the input signals only, to invert the comparator output signal in response to an inversion control signal and provide the thereby inverted comparator output signal to the counter (303, 510).

The counting direction may be changed during a first conversion of one of the input signals and then kept for a second conversion of the one of the input signals.

Thus the newly presented solution applies a very similar conversion technique and timing compared with the ADC shown in Fig. 1, but uses a single binary ripple counter 303, which can be transformed from up-to down counter without stopping the input clock signal. This can be achieved, for example, by internally stopping the clock while the externally applied clock keeps running. When toggling the counter direction, the local clock signal is gated for a known amount of clock pulses, which allows an error free counting direction change for the ripple counter, even at very high clock frequencies.

The circuit comprises a ripple counter which is based on JK flip-flops. In an alternative solution, the counter can be based on T flip flops. The function is that the counter can reverse direction. Other techniques providing reversible counting may be used. The counter direction can be inverted by toggling the MUX cells in between the JK flip-flops. In order to toggle the counting direction of ripple counter on an error-free manner, it is helpful for accuracy that the last clock cycle before toggling rippled through the asynchronous ripple counter completely. Therefore, in an exemplary implementation, a 'counter toggling state machine' 520 has been added (see Figure 5). At the moment the *"COMP_OUT"* signal toggles, this state machine 520 is triggered. The counter clock will be gated by this circuit for a pre-determined number of clock cycles. This time allows the ripple counter 303, 510 to settle. After settling of the ripple counter 303, 510 the *"CTR_DIR"* selection signal is toggled. Another clock cycle later the clock input is again applied to the ripple counter 303, 510.

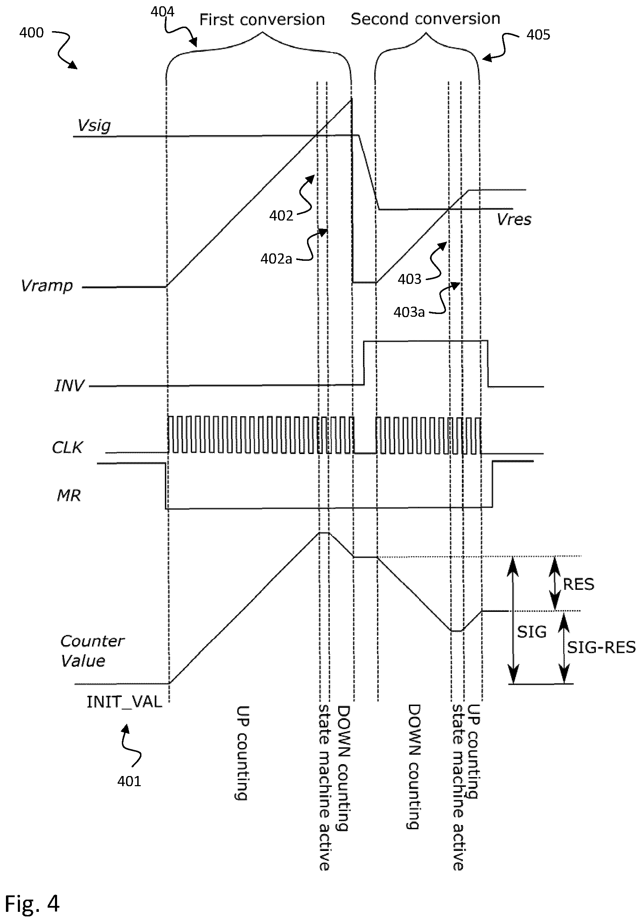

Fig. 4 shows an exemplary timing diagram 400 of the ADC 300 shown in Fig. 3.

The ADC 300 receives two analog signals which are a reset voltage Vᵣₑₛ and a signal voltage, V_{sig}. In the implementation of a sensor array, both signals may be received from a column output bus of the sensor array. The reset voltage may be a voltage of a pixel following reset. The signal voltage may be a voltage of a pixel following exposure to light during an exposure period. The ADC 300 converts a difference between the two analog signals, Vᵣₑₛ and V_{sig}, to a digital value. The ramp signal Vᵣₐₘₚ may be generated by a ramp generator, the clock signal CLK may be generated by a clock generator. Figure 4 shows operation of the ADC 300. In this example, one analog-to-digital conversion cycle to convert the difference between the two analog signals Vᵣₑₛ and V_{sig} occurs over two cycles of the ramp signal Vᵣₐₘₚ.

During a first cycle 404 of the ramp signal Vᵣₐₘₚ, V_{sig} is compared with the ramp signal, Vᵣₐₘₚ. The counter 303 is enabled based on the comparison and starts counting the Counter Value from an initial value INIT_VAL at start 401 of the A/D conversion cycle. Up-counting is enabled as long as the ramp voltage Vᵣₐₘₚ is below the signal level V_{sig}. Down-counting is enabled after the ramp voltage Vᵣₐₘₚ crosses the signal level V_{sig}, i.e. after time 402. The counter 303 stops counting when the clock signal CLK is inactive. Between times 402 and 402a state machine (as described herein with respect to Figure 5) is active.

During the second cycle 405 of the ramp signal Vᵣₐₘₚ, Vᵣₑₛ is compared with the ramp signal, Vᵣₐₘₚ. The counter 303 is enabled based on the comparison and continues counting. Down-counting is enabled as long as the ramp voltage Vᵣₐₘₚ is below the reset level Vᵣₑₛ. Up-counting is enabled after the ramp voltage Vᵣₐₘₚ crosses the reset level Vᵣₑₛ, i.e. after time 403. The counter 303 stops counting when the clock signal CLK is inactive. Between times 403 and 403a state machine (as described herein with respect to Figure 5) is active.

The INV signal is at low level during the first cycle of the ramp signal Vᵣₐₘₚ and at high level during the second cycle of the ramp signal Vᵣₐₘₚ. The MR signal is at low level during the first and second cycle of the ramp signal Vᵣₐₘₚ and otherwise at high level.

It can be seen, that the counter 303 counts both up and down during conversions. Counting direction is inverted during the reset conversion by means of inverting the comparator output 318. Fig. 4 also shows a possible *"dead time",* which is the time (or timeslot) between the two conversions 404, 405 (see definitions below). At this time, the INV signal goes high and the clock is idle as can be seen in Fig. 4. The dead time depends on circuit and topology details/implementation. It does not affect the counter value.

The control stage of the ADC may invert the counting direction of the counter during a conversion of one of the input signals (Vsig, Vres) without stopping the input clock (CLK). This provides the technical advantage that inverting the counting direction of the counter has no influence on the clocking of the ADC.

Inverting the counting direction without stopping the input clock enables toggling in a dynamic manner during a conversion. This enables the counter to be (on average) continuously active during a conversion, which assures a signal independent supply and ground for each individual ADC. As such cross talk through supply and ground nets between parallel ADC's is avoided.

In detail, the counter is (internally) stopped two times, a first time during times 402 and 402a and a second time during times 403 and 403a. These intervals are defined by an integer number of clock cycles (during which the state machine is active). However, the total number of counts (UP + DOWN) made does not depend on the input value. As such, on average, the counter is continuously active.

Inversion of the counting direction refers to changing from the first counting direction to the second counting direction or vice versa.

The control stage may be configured to invert the counting direction of the counter once during a reset conversion 404 and once during signal conversion 405.

A conversion 404, 405 for the input signal level refers to a time period during which the input signal level is compared against the ramp signal (Vramp). There is a corresponding conversion 404 for reset signal (Vres), and a corresponding conversion 405 for signal conversion (Vsig). A reset conversion 404 is based upon comparison of ramp signal with first analog signal level (Vsig) while signal conversion 405 is based upon comparison of ramp signal with second analog signal level (Vres).

For each conversion cycle of one input signal there is a fixed (predetermined) number of total counts (which, as per the existing solution, could be a number x for reset conversion and a number y for signal conversion), and there is a fixed (predetermined) number of counts gated by the state machine (as described herein with respect to Fig. 5).

For a first time part of each conversion, the counting direction is in one direction. For another part of each conversion, the counting direction is in the other direction. These parts may be adjacent in time, so that the other part is a second time part following the first time part. In a second conversion following a first conversion, the counting direction may be the same as that in the second time part of the first conversion.

In this disclosure, the following definitions apply:
"settle time": time required for the counter to propagate an increment to the last flop. The state machine has to make sure this time has elapsed before freezing the counter. Does not affect the counter value;
"count down time": time after the comparator has toggled AND the state machine has RE-ENABLED the counter. Depends on the value of the analog input signal. Does affect the counter value;
"dead time": time between two conversions. Depends on circuit and topology details/implementation. Does not affect the counter value.

Note that in a preferred implementation, counting is not inverted between reset and signal conversion. Rather, in this implementation, the counting direction may be changed during the first conversion and then kept for the second conversion. Note that not inverting implies to subtract the conversions while inverting implies to add two conversions.

In another exemplary implementation, both values may be stored in a register instead of keeping the counter value.

During the conversion of the signal, INV is low and the output of the comparator 301 is passed to the counter (state I). At a certain point 402, Vsig and Vramp cross and the comparator 301 toggles, thus inverting for the first time (state II). The clock keeps running for a few clock cycles longer (until 402a as shown in Fig. 4). Then the internal clock is stopped and the ramp is reset. The comparator 301 toggles again to the state that it initially was for the conversion of the signal (state I). Because the reset level needs to be subtracted, the counter needs to count down initially. Thus, the output of the comparator is inverted with the INV control (state III). The ramp and clock start and when the ramp crosses the reset level, the comparator 301 toggles a second time (state IV). And again the ADC counts for more clock cycles until the conversion is complete. As can be seen from Figure 4, the comparator 301 has toggled at least twice and counting is inverted twice. The inverted counting is kept after the first comparator toggle until the second comparator toggle.

The comparator 301 toggles four times. First toggle is from State I to State II. Second toggle refers to the reset to initial at end of first conversion cycle, from State II back to State I. A third toggle is from State III to State IV. A fourth toggle is from the State IV back to State I and thus refers to the end of the second conversion cycle.

Thus, the first toggle results in configuring of the counter of the first change of the counting direction (COUNT UP → COUNT DOWN).

The third toggle during the second conversion results in the second change of the configuration at the counter of the counting direction (COUNT DOWN →COUNT UP). The counter then counts to settled state.

Separately, the output of the comparator 301 is inverted by the control INV signal for the entire second (Vres) conversion time (but for only one of the conversions, not the higher level conversion), because Vres is assumed to be lower value than Vsignal and so counting down of the counter value is needed.

The conversions can be succinctly described as: UP (sig) -> DOWN (sig) -> clock stopped between conversions and ramp reset -> DOWN(res) -> UP(res).

In a preferred implementation, as illustrated in Figures 3 and 4, two values are converted without storing intermediate results.

Fig. 5 shows a block diagram of an exemplary counter circuitry 500 according to the disclosure for use in the ADC 300 shown in Fig. 3.

The counter circuitry 500 comprises a counter 510, e.g. corresponding to the Up/Down counter 303 shown in Fig. 3, and a state machine circuitry 520 for controlling the counter 510. The counter circuitry 500 comprises an input 532 for receiving the MR signal, e.g. as illustrated in Fig. 4, an input 533 for receiving the clock signal CLK, e.g. as shown in Fig. 4, and an input 534 for receiving the COMP_OUT signal, e.g. as shown in Fig. 3. An inverter 531 is used to invert the clock signal CLK to generate an inverted clock signal CLK_B at a further input 535.

The counter 510 is implemented by a series of flip-flops 511, e.g. JK flip-flops 511 and multiplexers 512 connected in between the flip-flops 511. The respective Q output of each flip-flop implements a respective output of the counter that can form part or all the counter value of the counter 510. In the example of Fig. 5, four flip-flops 511 are used where the counter value is formed by the values of B0, B1, B2 and B3. A clock control circuitry 514 enables clocking of the counter based on the inverted comparator output signal COMP_OUT and an output signal SM_FINISHED of the state machine circuitry 520 that signals a fully settled counter state.

The state machine circuitry 520 is implemented by a series of flip-flops 521, e.g. D flip-flops 521. The Q output of each flip-flop is connected to the D input of the next flip-flop in the series, the MR signal is applied to the R input of each flip-flop 521. The inverted comparator output signal COMP_OUT is applied to the D input of the first flip-flop 521. A clock control circuitry 523 enables a clocking of the state machine circuitry based on the inverted input clock CLK_B and the inverted comparator output signal COMP_OUT. The output signal SM_FINISHED is provided at the Q output of the last flip-flop of the state machine circuitry 520 for signaling a fully settled counter state.

The presented counter architecture eliminates the need of two counters and adder in a single column ADC. The actual counter 510 can be composed of the upper flip-flops 511, i.e. as shown on the upper part in Fig. 5. On the bottom side of Fig. 5, the state machine 520 can be seen. Clocks to both sections 510, 520 can be enabled through their respective latches.

Figure 5 shows a preferred embodiment for the counter circuitry according to the disclosure. The counter may also be referred to as a ripple counter. The ripple counter in this circuit 500 may be implemented as a counter counting on the rising edge of the clock signal. In an alternative example, a counter counting on the falling edge of the clock signal may also be implemented. The up/down toggling is configured by the MUX cells 512 in between the counter flip flops 511. These MUX cells 512 are controlled by the *"CTR_DIR"* signal, which originates from the 'counter toggling' state machine 520.

Note that in this implementation example shown in Fig. 5, the resolution of the ripple counter 500 is limited to 4 bits only. In practice the number of bits can be larger to accommodate for the desired ADC resolution.

The number of flip flops 521 in the state machine 520 can be adjusted to the required delay (or can be designed according to a required delay) for assuring a fully settled ripple counter state preceding the actual counter direction toggling. I.e., the last transition should ripple through the entire flip-flop chain. The required delay and the number of flip-flops may be in the following relation: When UD/COMP_OUT goes high, the input to the ripple counter 510 is frozen. The last clock pulse provided to this counter 510 needs to propagate from the input of bit-0 all to way up to bit-3. This delay is an intrinsic delay and will depend on the actual implementation (device parasitics, layout, technology, etc.). In the example shown in Fig. 5, the delay is fixed to a number of clock cycles.

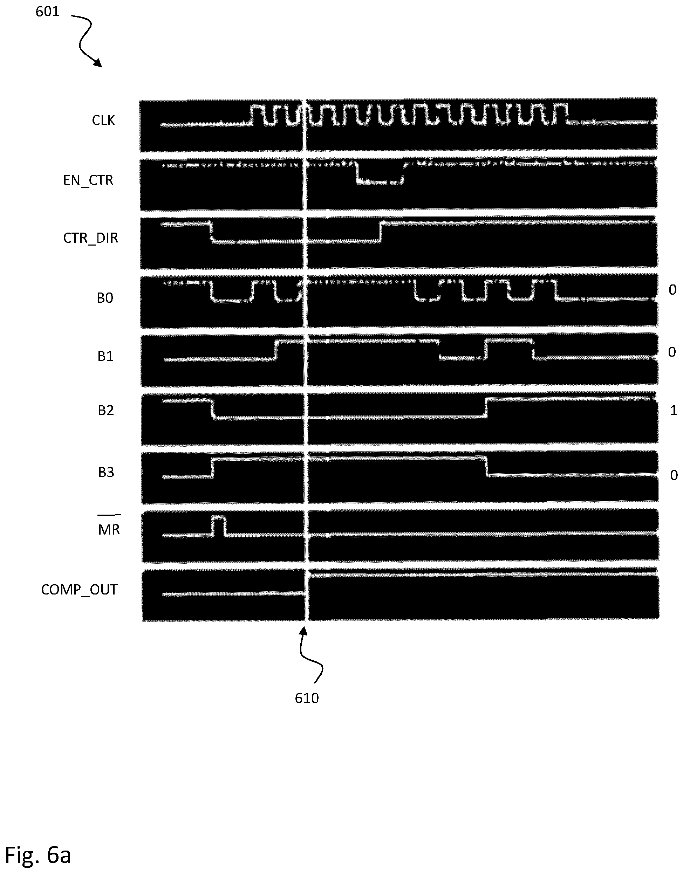

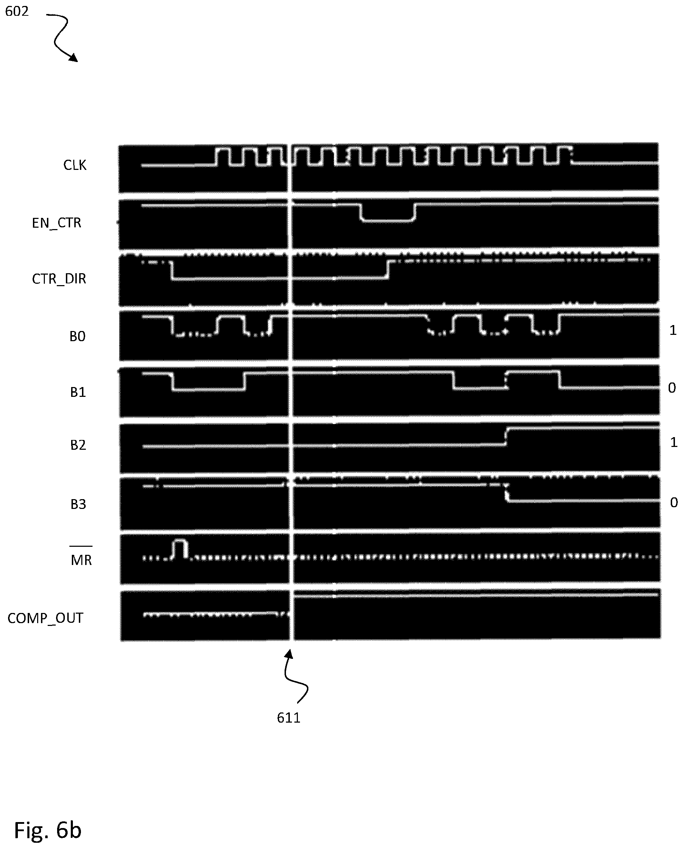

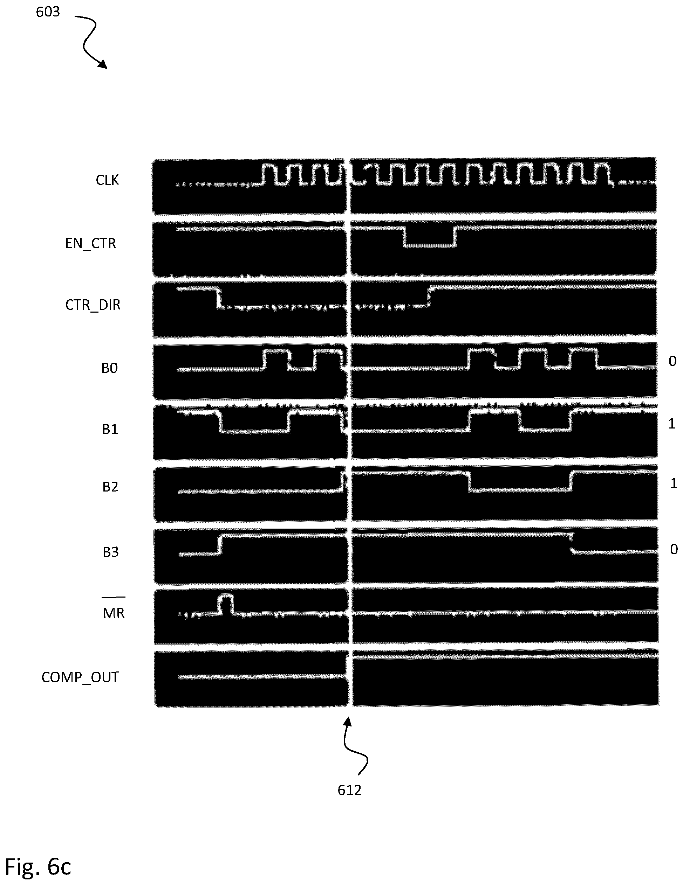

In this exemplary implementation shown in Fig. 5, the clock towards the local state machine 520 *("CLK_B")* is only active while the clock to the counter ("CLK") is de-activated. This clock is inverted, so in the state machine each flip flop 521 is clocked at the falling edge of the input clock. This inverse clocking edge is key to obtain two counts per ADC clock cycle. An illustration of this characteristic is shown in the timing diagrams 601, 602, 603 in Figures 6a, 6b and 6c. Note that in an alternative implementation, each flip flop 521 of the state machine circuitry may be clocked at the rising edge of the input clock.

Figures 6a, 6b and 6c show an exemplary timing diagrams 601, 602, 603 illustrating the 2-counts-per-clock-cycle operation of the ADC 300 shown in Fig. 3 and the counter circuitry 500 implementation shown in Fig. 5, where the comparator toggles after 2.5 clock cycles (Fig. 6a), after 3.0 clock cycles (Fig. 6b) and after 3.5 clock cycles (Fig. 6c). The timing diagrams 601, 602, 603 illustrate the 2-counts-per-clock-cycle operation.

Figures 6a, 6b, 6c show three timing diagrams 601, 602, 603 where the comparator 301 toggling is shifted by 0.5 clock period for each case. As an example, a 4 bit counter is used, e.g. a counter 510 as shown in Fig. 5 with outputs B0, B1, B2, B3. The reset condition is set to midrange, which is set by the specific connection of "MR". Pulsing "MR" low (or *"*/*MR"* high) resets both the state machine 520 and the counter 510. *"SM_FINISHED"* will be set to 0, disabling the clock to state machine until *"COMP_OUT"* goes high. On the other hand, the low value of *"SM_FINISHED"* enables the clock to the counter.

In the timing diagram 601 shown in Fig. 6a, the comparator toggles after 2.5 clock cycles (indicated by reference sign 610), the up-counter pauses at code 11 (B3=1, B2=0, B1=1, B0=1). At this point *"COMP_OUT"* goes high, which disables the clock to counter and enables the clock to the state machine 520. I.e., *"EN_CLK_CTR"* goes low and *"EN_CLK_SM"* goes high. The high value of *"COMP_OUT"* propagates through the state machine 520 on each falling edge of the clock. Arriving at the 4^{th} flop, it switches the direction of the counter 510: *"CTR_DIR"* goes from 0 to 1. When the high value passes the last flop in the state machine 520, the counter 510 is enabled again *("EN_CTR"* goes high again). In this configuration the counter 510 is programmed to count down. Afterwards, 7 down counts are done resulting in an output code of 4 (B3=0, B2=1, B1=0, B0=0), see right side of Fig. 6a.

In the timing diagram 602 shown in Fig. 6b, the comparator toggling is shifted by 0.5 clock cycles. As the counter 510 is counting on rising edge, this causes the same counter value of 11 (B3=1, B2=0, B1=1, B0=1) at the moment the counter 510 pauses (indicated by reference sign 611). However, since the state machine 520 is operating at falling clock edge, the pause period is delayed one clock cycle with respect to the timing diagram 601 shown in Fig. 6a. As such, only 6 down counts will be performed, resulting of an output count of 5 (B3=0, B2=1, B1=0, B0=1).

In the timing diagram 603 shown in Fig. 6c, an additional 0.5 clock period delay is added to the comparator toggling. This causes a counter value of 12 (B3=1, B2=1, B1=0, B0=0) at the moment the counter 510 pauses (indicated by reference sign 612).The resulting output code is 6 (B3=0, B2=1, B1=1, B0=0).

These examples demonstrate clearly that the circuit 500 yields 2 ADC counts per clock cycle, due to increasing the output code by 1 for every 0.5 clock cycle.

In an exemplary implementation, the *"COMP_OUT"* signal is also inverted when converting the reset value. This is required because the reset signal is subtracted from the signal level. In another implementation example, synchronization is implemented between the clock and the other control signals or comparator output (*"COMP_OUT*")*.* In another implementation counter overflow is correctly handled and/or detected.

While a particular feature or aspect of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Also, the terms "exemplary", "for example" and "e.g." are merely meant as an example, rather than the best or optimal. The terms "coupled" and "connected", along with derivatives may have been used. It should be understood that these terms may have been used to indicate that two elements cooperate or interact with each other regardless whether they are in direct physical or electrical contact, or they are not in direct contact with each other.

Although specific aspects have been illustrated and described herein, it will be appreciated by those of ordinary skill in the art that a variety of alternate and/or equivalent implementations may be substituted for the specific aspects shown and described without departing from the scope of the present disclosure. This application is intended to cover any adaptations or variations of the specific aspects discussed herein.

Although the elements in the following claims are recited in a particular sequence with corresponding labeling, unless the claim recitations otherwise imply a particular sequence for implementing some or all of those elements, those elements are not necessarily intended to be limited to being implemented in that particular sequence.

Many alternatives, modifications, and variations will be apparent to those skilled in the art in light of the above teachings. Of course, those skilled in the art readily recognize that there are numerous applications of the invention beyond those described herein. While the present invention has been described with reference to one or more particular embodiments, those skilled in the art recognize that many changes may be made thereto without departing from the scope of the present invention. It is therefore to be understood that within the scope of the appended claims the invention may be practiced otherwise than as specifically described herein.

## Claims

1. An analog-to-digital converter (300), ADC, configured to enable a calculation of a difference between a first analog signal level (Vsig) and a second analog signal level (Vres), the ADC (300) comprising:
at least one input (311) for receiving an input signal, comprising one of the first analog signal level (Vsig) and the second analog signal level (Vres);
an input (310) for receiving a ramp signal (Vramp);
an input (313) for receiving an input clock (CLK);
a counter (303), wherein the counter is a single counter configurable to count in a counting direction being either of a first counting direction and a second counting direction;
a comparator (301), configured to generate a comparator output signal based on a comparison of the ramp signal (Vramp) with the input signal; and
a control stage, configured to enable the counter (303) to count in the first counting direction based on the comparator output signal, and to enable the counter (303) to count in the second counting direction based on an inversion of the comparator output signal, and wherein the control stage is configured to invert the counting direction of the counter (303) during a conversion of one of the input signals without stopping the input clock (CLK) by gating a local clock for a known amount of clock pulses when the counter direction of the counter is toggled between the first counting direction and the second counting direction.

2. The ADC (300) of claim 1,
wherein the counter (303, 510) comprises a plurality of flip-flops (511) connected in series, in particular JK flip-flops or T flip-flops.

3. The ADC (300) of claim 2,
wherein the counter (303, 510) comprises a plurality of multiplexer cells (512), each multiplexer cell (512) connected between an output and an input of two consecutive flip-flops (511) of the counter (510),
wherein the control stage is configured to invert the counting direction of the counter (510) by toggling the multiplexer cells (512) in between the flip-flops (511).

4. The ADC (300) of claim 3,
wherein the control stage is configured to let a last clock cycle of the input clock (CLK) before toggling the multiplexer cells (512) completely pass through the counter (510).

5. The ADC (300) of one of the preceding claims, comprising:
a state machine circuitry (520) composed of a plurality of flip-flops (521) connected in series, wherein a Q output of each flip-flop is connected to a D input of the next flip-flop in the series, and an output signal (SM_FINISHED) is provided at the Q output of a last flip-flop of the state machine circuitry 520 to signal a fully settled counter state.

6. The ADC (300) of claim 5,
wherein the control stage is configured to trigger the state machine circuitry (520) based on the inversion of the comparator output signal.

7. The ADC (300) of claim 5 or 6,
wherein a number of flip-flops (521) of the state machine circuitry (520) is predetermined according to a delay for a settled counter state preceding the inversion of the counting direction.

8. The ADC (300) of one of claims 5 to 7,
wherein the counter (303) comprises a clock control circuitry (514) configured to enable a clocking of the counter (510) based on the inversion of the comparator output signal and the output signal (SM_FINISHED) of the state machine circuitry (520) signaling for a settled counter state.

9. The ADC (300) of one of claims 5 to 8,
comprising an input configured to receive an inverted input clock (CLK_B) corresponding to the input clock (CLK) inverted by an inverter.

10. The ADC (300) of claim 9,
wherein the state machine circuitry (520) comprises a clock control circuitry (523) configured to enable a clocking of the state machine circuitry (520) based on the inverted input clock (CLK_B) or based on the input clock (CLK).

11. The ADC (300) of one of claims 5 to 10,
wherein the control stage is configured to:
de-activate a clocking of the counter (303, 510) by the input clock (CLK) based on the inversion of the comparator output signal; and
activate a clocking of the state machine circuitry (520) by the inverted input clock (CLK_B) upon a de-activation of the clocking of the counter by the input clock (CLK).

12. The ADC (300) of one of claims 5 to 11,
wherein the counter (303, 510) is configured to perform two counts per clock cycle of the input clock (CLK), wherein the two counts per clock cycle comprise clocking the counter (303, 510) on one edge of the input clock (CLK) and clocking the state machine circuitry (520) on the other edge of the input clock (CLK).

13. The ADC (300) of one of the preceding claims,
wherein the counter (303, 510) is up/down reversible in response to a direction control signal from the state machine circuitry (520) based on the comparator output signal.

14. The ADC (300) of any of the preceding claims,
wherein the control stage is configured, for conversion of one of the input signals only, to invert the comparator output signal in response to an inversion control signal and provide the thereby inverted comparator output signal to the counter (303, 510).

15. The ADC (300) of any of the preceding claims,
wherein the counting direction is changed during a first conversion of one of the input signals and then kept for a second conversion of the one of the input signals.

## Patentansprüche

1. Analog-Digital-Wandler (300), ADC, der konfiguriert ist, um eine Berechnung einer Differenz zwischen einem ersten Analogsignalpegel (Vsig) und einem zweiten Analogsignalpegel (Vres) zu ermöglichen, wobei der ADC (300) umfasst:
mindestens einen Eingang (311) zum Empfangen eines Eingangssignals, das einen des ersten Analogsignalpegels (Vsig) und des zweiten Analogsignalpegels (Vres) umfasst;
einen Eingang (310) zum Empfangen eines Rampensignals (Vramp);
einen Eingang (313) zum Empfangen eines Eingangstakts (CLK);
einen Zähler (303), wobei der Zähler ein einzelner Zähler ist, der konfigurierbar ist, um in einer Zählrichtung, die eine von einer ersten Zählrichtung und einer zweiten Zählrichtung ist, zu zählen;
einen Vergleicher (301), der konfiguriert ist, um basierend auf einem Vergleich des Rampensignals (Vramp) mit dem Eingangssignal ein Vergleicherausgangssignal zu erzeugen; und
eine Steuerstufe, die konfiguriert ist, um dem Zähler (303) zu ermöglichen, basierend auf dem Vergleicherausgangssignal in der ersten Zählrichtung zu zählen, und um dem Zähler (303) zu ermöglichen, basierend auf einer Inversion des Vergleicherausgangssignals in der zweiten Zählrichtung zu zählen, und wobei die Steuerstufe konfiguriert ist, um die Zählrichtung des Zählers (303) während einer Umwandlung eines der Eingangssignale ohne ein Anhalten des Eingangstakts (CLK) durch Verknüpfen eines Systemtakts für eine bekannte Menge an Taktimpulsen zu invertieren, wenn die Zählerrichtung des Zählers zwischen der ersten Zählrichtung und der zweiten Zählrichtung umgeschaltet wird.

2. ADC (300) nach Anspruch 1,
wobei der Zähler (303, 510) eine Vielzahl von in Reihe geschalteten Flipflops (511), insbesondere JK-Flipflops oder T-Flipflops, umfasst.

3. ADC (300) nach Anspruch 2,
wobei der Zähler (303, 510) eine Vielzahl von Multiplexerzellen (512) umfasst, wobei jede Multiplexerzelle (512) zwischen einen Ausgang und einen Eingang von zwei aufeinanderfolgenden Flipflops (511) des Zählers (510) geschaltet ist,
wobei die Steuerstufe konfiguriert ist, um die Zählrichtung des Zählers (510) durch Umschalten der Multiplexerzellen (512) zwischen den Flipflops (511) zu invertieren.

4. ADC (300) nach Anspruch 3,
wobei die Steuerstufe konfiguriert ist, um einen letzten Taktzyklus des Eingangstakts (CLK) vor dem Umschalten der Multiplexerzellen (512) vollständig den Zähler (510) durchlaufen zu lassen.

5. ADC (300) nach einem der vorstehenden Ansprüche, der umfasst:
eine Zustandsmaschinenschaltung (520), die aus einer Vielzahl von in Reihe geschalteten Flipflops (521) besteht, wobei ein Q-Ausgang jedes Flipflops mit einem D-Eingang des nächsten Flipflops in der Reihe geschaltet ist und ein Ausgangssignal (SM_FINISHED) an dem Q-Ausgang eines letzten Flipflops der Zustandsmaschinenschaltung 520 bereitgestellt ist, um einen vollständig eingeschwungenen Zählerzustand zu signalisieren.

6. ADC (300) nach Anspruch 5,
wobei die Steuerstufe konfiguriert ist, um die Zustandsmaschinenschaltung (520) basierend auf der Inversion des Vergleicherausgangssignals auszulösen.

7. ADC (300) nach Anspruch 5 oder 6,
wobei eine Anzahl von Flipflops (521) der Zustandsmaschinenschaltung (520) gemäß einer Verzögerung für einen eingeschwungenen Zählerzustand vorhergehend der Inversion der Zählrichtung vorbestimmt ist.

8. ADC (300) nach einem der Ansprüche 5 bis 7,
wobei der Zähler (303) eine Taktsteuerschaltung (514) umfasst, die konfiguriert ist, um eine Taktung des Zählers (510) basierend auf der Inversion des Vergleicherausgangssignals und des Ausgangssignals (SM_FINISHED) der Zustandsmaschinenschaltung (520), das einen eingeschwungenen Zählerzustand signalisiert, zu ermöglichen.

9. ADC (300) nach einem der Ansprüche 5 bis 8,
der einen Eingang umfasst, der konfiguriert ist, um einen invertierten Eingangstakt (CLK_B), der dem durch einen Inverter invertierten Eingangstakt (CLK) entspricht, zu empfangen.

10. ADC (300) nach Anspruch 9,
wobei die Zustandsmaschinenschaltung (520) eine Taktsteuerschaltung (523), die konfiguriert ist, um eine Taktung der Zustandsmaschinenschaltung (520) basierend auf dem invertierten Eingangstakt (CLK_B) oder basierend auf dem Eingangstakt (CLK) zu ermöglichen, umfasst.

11. ADC (300) nach einem der Ansprüche 5 bis 10,
wobei die Steuerstufe konfiguriert ist zum:
Deaktivieren einer Taktung des Zählers (303, 510) durch den Eingangstakt (CLK) basierend auf der Inversion des Vergleicherausgangssignals; und
Aktivieren einer Taktung der Zustandsmaschinenschaltung (520) durch den invertierten Eingangstakt (CLK_B) bei einer Deaktivierung der Taktung des Zählers durch den Eingangstakt (CLK).

12. ADC (300) nach einem der Ansprüche 5 bis 11,
wobei der Zähler (303, 510) konfiguriert ist, um zwei Zählungen pro Taktzyklus des Eingangstakts (CLK) durchzuführen, wobei die zwei Zählungen pro Taktzyklus die Taktung des Zählers (303, 510) an einer Flanke des Eingangstakts (CLK) und die Taktung der Zustandsmaschinenschaltung (520) an der anderen Flanke des Eingangstakts (CLK) umfassen.

13. ADC (300) nach einem der vorstehenden Ansprüche,
wobei der Zähler (303, 510) als Reaktion auf ein Richtungssteuersignal von der Zustandsmaschinenschaltung (520) basierend auf dem Vergleicherausgangssignal aufwärts/abwärts umkehrbar ist.

14. ADC (300) nach einem der vorstehenden Ansprüche,
wobei die Steuerstufe konfiguriert ist, um für die Umwandlung nur eines der Eingangssignale das Vergleicherausgangssignal als Reaktion auf ein Inversionssteuersignal zu invertieren und das dadurch invertierte Vergleicherausgangssignal dem Zähler (303, 510) bereitzustellen.

15. ADC (300) nach einem der vorstehenden Ansprüche,
wobei die Zählrichtung während einer ersten Umwandlung eines der Eingangssignale geändert und dann für eine zweite Umwandlung des einen der Eingangssignale beibehalten wird.

## Revendications

1. Convertisseur analogique-numérique (300), CAN, configuré pour permettre un calcul d'une différence entre un premier niveau de signal analogique (Vsig) et un second niveau de signal analogique (Vres), le CAN (300) comprenant :
au moins une entrée (311) pour recevoir un signal d'entrée, comprenant l'un du premier niveau de signal analogique (Vsig) et du second niveau de signal analogique (Vres) ;
une entrée (310) pour recevoir un signal de rampe (Vramp) ;
une entrée (313) pour recevoir une horloge d'entrée (CLK) ;
un compteur (303), dans lequel le compteur est un compteur unique configurable pour compter dans un sens de comptage, soit dans un premier sens de comptage, soit dans un second sens de comptage ;
un comparateur (301), configuré pour générer un signal de sortie de comparateur sur la base d'une comparaison du signal de rampe (Vramp) avec le signal d'entrée ; et
un étage de commande, configuré pour permettre au compteur (303) de compter dans le premier sens de comptage sur la base du signal de sortie de comparateur, et pour permettre au compteur (303) de compter dans le second sens de comptage sur la base d'une inversion du signal de sortie de comparateur, et dans lequel l'étage de commande est configuré pour inverser le sens de comptage du compteur (303) pendant une conversion de l'un des signaux d'entrée sans arrêter l'horloge d'entrée (CLK) en bloquant une horloge locale pour une quantité connue d'impulsions d'horloge lorsque le sens de comptage du compteur est basculé entre le premier sens de comptage et le second sens de comptage.

2. CAN (300) selon la revendication 1,
dans lequel le compteur (303, 510) comprend une pluralité de bascules (511) connectées en série, en particulier des bascules JK ou des bascules T.

3. CAN (300) selon la revendication 2,
dans lequel le compteur (303, 510) comprend une pluralité de cellules de multiplexage (512), chaque cellule de multiplexage (512) étant connectée entre une sortie et une entrée de deux bascules consécutives (511) du compteur (510),
dans lequel l'étage de commande est configuré pour inverser le sens de comptage du compteur (510) en basculant les cellules de multiplexage (512) entre les bascules (511).

4. CAN (300) selon la revendication 3,
dans lequel l'étage de commande est configuré pour laisser un dernier cycle d'horloge de l'horloge d'entrée (CLK) avant le basculement des cellules de multiplexage (512) passer complètement par le compteur (510).

5. CAN (300) selon l'une des revendications précédentes,
une circuiterie de machine à états (520) composée d'une pluralité de bascules (521) connectées en série, dans lequel une sortie Q de chaque bascule est connectée à une entrée D de la bascule suivante dans la série, et un signal de sortie (SM_FINISHED) est fourni au niveau de la sortie Q d'une dernière bascule de la circuiterie de machine à états 520 pour signaler un état de compteur complètement établi.

6. CAN (300) selon la revendication 5,
dans lequel l'étage de commande est configuré pour déclencher la circuiterie de machine à états (520) sur la base de l'inversion du signal de sortie de comparateur.

7. CAN (300) selon la revendication 5 ou 6,
dans lequel un nombre de bascules (521) de la circuiterie de machine à états (520) est prédéterminé selon un délai pour un état de compteur établi précédant l'inversion du sens de comptage.

8. CAN (300) selon l'une des revendications 5 à 7,
dans lequel le compteur (303) comprend une circuiterie de commande d'horloge (514) configurée pour activer une synchronisation par horloge du compteur (510) sur la base de l'inversion du signal de sortie de comparateur et du signal de sortie (SM_FINISHED) de la circuiterie de machine à états (520) signalant un état de compteur établi.

9. CAN (300) selon l'une des revendications 5 à 8,
comprenant une entrée configurée pour recevoir une horloge d'entrée inversée (CLK_B) correspondant à l'horloge d'entrée (CLK) inversée par un inverseur.

10. CAN (300) selon la revendication 9,
dans lequel la circuiterie de machine à états (520) comprend une circuiterie de commande d'horloge (523) configurée pour activer une synchronisation par horloge de la circuiterie de machine à états (520) sur la base de l'horloge d'entrée inversée (CLK_B) ou sur la base de l'horloge d'entrée (CLK).

11. CAN (300) selon l'une des revendications 5 à 10,
dans lequel l'étage de commande est configuré pour :
désactiver une synchronisation par horloge du compteur (303, 510) par l'horloge d'entrée (CLK) sur la base de l'inversion du signal de sortie de comparateur ; et
activer une synchronisation par horloge de la machine à états (520) par l'horloge d'entrée inversée (CLK_B) lors de la désactivation de la synchronisation par horloge du compteur par l'horloge d'entrée (CLK).

12. CAN (300) selon l'une des revendications 5 à 11,
dans lequel le compteur (303, 510) est configuré pour réaliser deux comptages par cycle d'horloge de l'horloge d'entrée (CLK), dans lequel les deux comptages par cycle d'horloge comprennent la synchronisation par horloge du compteur (303, 510) sur un front de l'horloge d'entrée (CLK) et la synchronisation par horloge de la circuiterie de machine à états (520) sur l'autre front de l'horloge d'entrée (CLK).

13. CAN (300) selon l'une des revendications précédentes,
dans lequel le compteur (303, 510) est réversible haut/bas en réponse à un signal de commande de sens provenant de la circuiterie de machine à états (520) sur la base du signal de sortie de comparateur.

14. CAN (300) selon l'une quelconque des revendications précédentes,
dans lequel l'étage de commande est configuré, pour la conversion de l'un des signaux d'entrée uniquement, pour inverser le signal de sortie de comparateur en réponse à un signal de commande d'inversion et fournir le signal de sortie de comparateur ainsi inversé au compteur (303, 510).

15. CAN (300) selon l'une quelconque des revendications précédentes,
dans lequel le sens de comptage est modifié lors d'une première conversion de l'un des signaux d'entrée puis conservé pour une seconde conversion de l'un des signaux d'entrée.
